Europäisches Patentamt

European Patent Office

Office européen des brevets

(19)

(11) **EP 0 515 357 B1**

(12) **EUROPÄISCHE PATENTSCHRIFT**

(45) Veröffentlichungstag und Bekanntmachung des Hinweises auf die Patenterteilung:
**10.01.1996 Patentblatt 1996/02**

(21) Anmeldenummer: **90902997.7**

(22) Anmeldetag: **14.02.1990**

(51) Int Cl.[6]: **H04N 11/18**, H04N 9/66

(86) Internationale Anmeldenummer:
**PCT/DE90/00097**

(87) Internationale Veröffentlichungsnummer:
**WO 91/12696 (22.08.1991 Gazette 1991/19)**

(54) **VERFAHREN ZUR DEMODULATION VON SECAM-CODIERTEN FARBFERNSEHSIGNALEN MIT ZEILENVERKOPPELTEM TAKT UND SCHALTUNGSANORDNUNG ZUR DURCHFÜHRUNG DES VERFAHRENS**

PROCESS FOR THE DEMODULATION OF SECAM-CODED COLOUR-TELEVISION SIGNALS WITH A LINE-COUPLED CYCLE, AND A CIRCUIT FOR CARRYING OUT THE PROCESS

PROCEDE ET CIRCUIT DE DEMODULATION DE SIGNAUX DE TELEVISION EN COULEURS A CODAGE SECAM A FREQUENCE ELEMENTAIRE COUPLEE AUX LIGNES

(84) Benannte Vertragsstaaten:
**DE ES FR GB IT**

(43) Veröffentlichungstag der Anmeldung:
**02.12.1992 Patentblatt 1992/49**

(73) Patentinhaber:
**SIEMENS AKTIENGESELLSCHAFT
D-80333 München (DE)**

(72) Erfinder: **KRAMER, Ronalf
D-8000 München 60 (DE)**

(56) Entgegenhaltungen:
**EP-A- 0 308 709          DE-A- 3 243 014
US-A- 4 689 664**

- **Elektronik, Band 36, Nr. 5, 6. Marz 1987, (Munchen, DE), W. MORING: "Chrominanzdemodulation im TV-Decoder mit Zeilenverkopplung", seiten 105-108**

EP 0 515 357 B1

## Beschreibung

Die Erfindung betrifft ein Verfahren zur Demodulation von SECAM-codierten Farbfernsehsignalen mit zeilenverkoppeltem Takt und eine Schaltungsanordnung zur Durchführung des Verfahrens.

Ein solches Verfahren wird beispielsweise im digitalen SECAM-Decoder SAA 9055 von Philips angewandt. Dabei handelt es sich um einen als Nulldurchgangsdemodulator mit Echtzeitteilung ausgebildetem FM-Demodulator, der die Nulldurchgänge des Chrominanzsignales erfaßt und daraus das fm-demodulierte Chrominanzsignal bildet. Bei diesen Verfahren, das in NTZ, Bd 37, 1984, Seiten 414 bis 419 beschrieben ist, ist auch bei der Verwendung eines zeilenverkoppelten Taktsystemes kein phasenstabiler Farbträger notwendig.

Da die heute üblichen Farbfernsehempfänger sowohl zum Empfang von SECAM-Fernsehsignalen als auch zum Empfang von PAL- und NTSC-, also quadraturamplitudenmodulierten Fernsehsignalen geeignet sein müssen, ist zwangsweise neben einem SECAM-Decoder auch ein PAL/NTSC-Decoder notwendig. Das Verfahren zur Demodulation von PAL/NTSC-Farbsignalen unterscheidet sich jedoch so grundsätzlich von dem Verfahren zur Demodulation von SECAM-Fernsehsignalen, daß bisher immer zwei unterschiedliche Schaltungskonzepte und damit jeweils eigene integrierte Schaltkreise zu deren Realisation verwendet werden mußten.

Im Gegensatz zur bisherigen Demodulation von SECAM-Farbsignalen werden nämlich bei der Demodulation von PAL/NTSC-Farbsignalen in zeilenverkoppelten Taktsystemen (vgl. dazu Elektronik 5/6, 1987, Seite 105 bis 108) beispielsweise in einem ersten Phasenregelkreis zwei um 90° zueinander phasenverschobene Farbträger erzeugt, wobei Schwankungen der zeilenverkoppelten Taktfrequenz durch ein Korrektursignal kompensiert werden. Das Korrektursignal selbst wird, da der erste Phasenregelkreis eine zu große Zeitkonstante und damit eine zu geringe Eigenfrequenz (Schleifenlaufzeit im µsec-Bereich, z. B. 64 µsec) aufweist und deshalb Schwankungen der zeilenverkoppelten Taktfrequenz durch diesen Phasenregelkreis nicht mehr kompensiert werden können, aus einem zweiten Phasenregelkreis abgeleitet. Dieses Korrektursignal wird dann als Divisor einer arithmetischen Teilung zugeführt, die relativ viel Zeit in Anspruch nimmt, da das Ergebnis auf etwa $10^{-6}$ genau berechnet werden muß. Da - wie bereits erwähnt - der erste Phasenregelkreis für die PAL bzw. NTSC-Decodierung große Zeitkonstanten besitzt, ändert sich das Steuersignal jedoch nur sehr langsam, so daß der große Zeitaufwand unerheblich ist. Dieses Konzept eignet sich jedoch nicht zur SECAM-Demodulation, so daß bisher zwei getrennte integrierte Schaltkreise in den Farbfernsehempfängern vorgesehen werden.

Aus der DE-A 32 43 014 ist ein Verfahren bekannt, mit dem durch Bauteiletoleranzen verursachte Streuungen eines VCO-Oszillators kompensiert werden, so daß durch diese Streuungen keine Verfälschung der demodulierten Chrominanz mehr auftritt. Hierzu wird die Zeilenfrequenz als Referenzfrequenz benutzt und daher auch als stabil vorausgesetzt. Wenn diese Frequenz jedoch schwankt, wird auch das demodulierte Signal verfälscht.

Der Erfindung liegt die Aufgabe zugrunde, ein Verfahren zur Demodulation von SECAM-codierten Farbfernsehsignalen und eine Schaltungsanordnung zur Durchführung dieses Verfahrens anzugeben, das in einfacher Weise eine zuverlässige FM-Demodulation von SECAM-Chrominanzsignalen auch bei nicht stabiler Zeilenfrequenz ermöglicht. Dabei sollen Verfahrensschritte und Schaltungskomponenten zur Demodulation von PAL/NTSC-codierten Farbsignalen so weit wie möglich genutzt werden können, wodurch die Integration sowohl des SECAM-Decoders als auch des PAL/NTSC-Decoders auf einem Halbleiterkörper möglich wird.

Diese Aufgabe wird für ein Verfahren durch die Merkmale des Anspruchs 1 und für eine Schaltungsanordnung zur Durchführung des Verfahrens durch die Merkmale des Anspruchs 7 gelöst.

Weiterbildungen der Erfindung sind Gegenstand der Unteransprüche.

Von besonderem Vorteil bei der vorliegenden Erfindung ist die SECAM-Demodulation mit Zeilenverkopplung mittels eines Phasenregelkreises. Da die Verwendung eines Phasenregelkreises auch bei der PAL/NTSC-Demodulation von Farbsignalen unbedingt notwendig ist, erlaubt es die Erfindung in einfacher Weise, diesen Phasenregelkreis sowohl zur SECAM-Demodulation als auch PAL/ NTSC-Demodulation zu verwenden.

In einer Weiterbildung der Erfindung wird das für die SECAM-Demodulation notwendige Korrektursignal aus einem zweiten Phasenregelkreis erzeugt, der ohnehin bei der PAL/NTSC-Demodulation auch notwendig ist. Damit kann auch dieser zweite Phasenregelkreis sowohl für die SECAM-Demodulation als auch die PAL/NTSC-Demodulation eingesetzt werden.

Es sind also die wesentlichsten Schaltungselemente zur Demodulation von SECAM-codierten Farbfernsehsignalen mit zeilenverkoppeltem Takt identisch zu denen bei der PAL/NTSC-Demodulation, so daß eine einfache Integration auf einem Halbleiterkörper möglich ist und die Verwendung von zwei getrennten integrierten Schaltkreisen vermieden wird. Damit wird aber eine kostengünstige Realisierung für einen Multistandard-Farbdecoder erreicht.

Die Erfindung wird im folgenden anhand von fünf Figuren näher erläutert.

Es zeigen:

FIG 1 ein Prinzipschaltbild der Erfindung mit einem ersten Phasenregelkreis,

FIG 2 ein Prinzipschaltbild nach FIG 1, bei der das Korrektursignal des ersten Phasenregelkreises aus einem zweiten Phasenregelkreis abgeleitet wird,

FIG 3 ein Prinzipschaltbild eines Multistandard-Farbdecoders zum Demodulieren von PAL/NTSC und SECAM-codierten Chrominanzsignalen,

FIG 4 ein Beispiel einer möglichen Korrektureinrichtung zum Erzeugen eines Korrektursignales, das mindestens annähernd umgekehrt proportional zur zeilenverkoppelten Taktfrequenz ist und

FIG 5 ein Prinzip einer möglichen Approximation in der Korrektureinrichtung

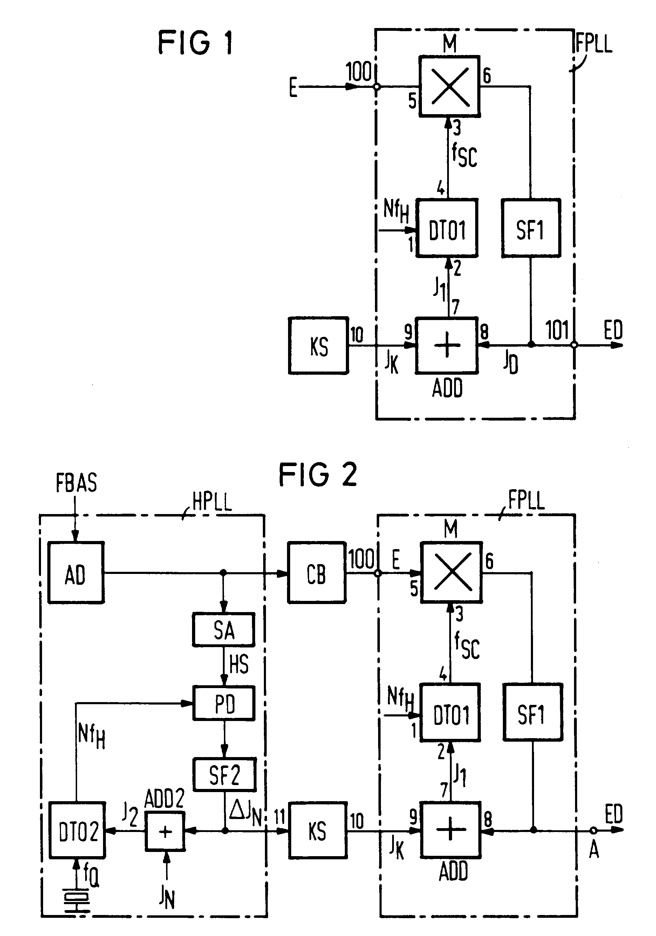

Das erfindungsgemäße Verfahren zur Demodulation von SECAM-codierten Farbfernsehsignalen mit zeilenverkoppeltem Takt wird im folgenden anhand einer in FIG 1 dargestellten Schaltungsanordnung zur Durchführung des Verfahrens im einzelnen vorgestellt. Die Schaltungsanordnung weist einen ersten Phasenregelkreis FPLL auf, der im wesentlichen einen ersten digitalen Nachlaufoszillator DTO1 (ein sogenannter Diskret Time Oscillator) mit einer ersten Eingangsklemme 1 zum Anlegen eines zeilenverkoppelten Taktes $Nf_H$ und eine zweite Eingangsklemme 2 zum Anlegen eines ersten Inkrementes $J_1$. Ein Modulator M ist mit seiner ersten Eingangsklemme 3 mit der Ausgangsklemme 4 des ersten digitalen Nachlaufoszillators DTO1 verbunden. An die zweite Eingangsklemme 5 des Modulators M wird das zu demodulierende Chrominanzsignal E über einen Eingang 100 des ersten Phasenregelkreises FPLL gelegt. Weiterhin weist dieser erste Phasenregelkreis FPLL ein erstes Schleifenfilter SF1 auf, das zwischen eine Ausgangsklemme 6 des Modulators M und einem Ausgang 101 des ersten Phasenregelkreises FPLL geschaltet ist. Zusätzlich ist eine Additionsstufe ADD vorgesehen, deren Ausgangsklemme 7 mit der zweiten Eingangsklemme 2 des ersten digitalen Nachlaufoszillators DTO1 verbunden und deren erste Eingangsklemme 8 an den Ausgang 101 des ersten Phasenregelkreises FPLL angeschlossen ist. Über eine Korrektureinrichtung KS wird der Additionsstufe ADD ein Korrektursignal $J_K$ zugeführt, das mindestens annähernd umgekehrt proportional zur Frequenz des zeilenverkoppelten Taktes $Nf_H$ ist, welches an einer Ausgangsklemme 10 dieser Korrektureinrichtung KS abgreifbar ist und einer zweiten Eingangsklemme 9 der Additionsstufe ADD zugeführt wird. Am Eingang 2 des digitalen Nachlaufoszillators DTO1 liegt damit ein Inkrement $J_I$ an, das aus der Summe des Korrektursignales $J_K$ und dem demodulierten SECAM-Chrominanzsignal ED, das hier mit $J_D$ bezeichnet ist, gebildet wird.

Durch diese Schaltungsanordnung wird im ersten Phasenregelkreis FPLL das zu demodulierende Chrominanzsignal E mit dem phasenstabilen Farbträger $f_{SC}$ an der Ausgangsklemme 4 des digitalen Nachlaufoszillators DTO1 multipliziert und anschließend mindestens dem Schleifenfilter SF1 zugeführt, an dessen Ausgang das demodulierte Chrominanzsignal ED anliegt. Die Frequenz des phasenstabilen Farbträgers $f_{SC}$ ist dabei zum Produkt aus dem Inkrement $J_I$ und dem zeilenverkoppelten Takt $Nf_H$, wie dies bei digitalen Nachlaufoszillatoren an sich bekannt ist, proportional. Wesentlich dabei ist, daß das Inkrement $J_1$ gemäß der Erfindung aus der Addition des demodulierten Chrominanzsignales $J_D$ und einem Korrektursignal $J_K$ gebildet wird, das umgekehrt proportional zur Frequenz des zeilenverkoppelten Taktes $Nf_H$ gewählt ist.

In diesem ersten Phasenregelkreis FPLL können durch die Addition eines Korrektursignales $J_K$, das umgekehrt proportional zur augenblicklichen Frequenz des zeilenverkoppelten Taktes $Nf_H$ ist, Taktschwankungen des zeilenverkoppelten Taktes $Nf_H$ kompensiert werden. Die einwandfreie Demodulation von SECAM-Signalen setzt eine geringe Schleifenlaufzeit des ersten Phasenregelkreises FPLL voraus, da die Eigenfrequenz im Bereich der höchsten Signalfrequenz des demodulierten SECAM-Chrominanzsignales ED, also bei einigen MHz, liegen muß. Im Gegensatz zur arithmetischen Teilung, wie diese bei der PAL/NTSC-Demodulation notwendig ist, beansprucht die erfindungsgemäß vorgeschlagene Addition aber relativ wenig Zeit, so daß die Forderung nach geringer Schleifenlaufzeit erfüllt wird.

Im folgenden wird anhand von FIG 2 dargestellt, wie das Korrektursignal $J_K$ in einfacher Weise bereitgestellt werden kann. Dazu weist die Schaltungsanordnung einen zweiten Phasenregelkreis HPLL auf, der zum Generieren des zeilenverkoppelten Taktes $Nf_H$ aus einem Synchronsignal HS, vorzugsweise dem Horizontalsynchronsignal, des Farbfernsehsignales FBAS geeignet ist. Ein solcher zweiter Phasenregelkreis HPLL ist an sich für die Demodulation von PAL/NTSC-Chrominanzsignalen bekannt (vgl. dazu Elektronik 5/6, 1987, Seite 105 bis 108, Bild 3). Dieser zweite Phasenregelkreis HPLL verfügt beispielsweise über einen Analog-Digital-Wandler AD, an dessen Eingang das analoge Farbfernsehsignal FBAS anliegt und dessen Ausgang mit einem Chromabandpaß CB verbunden ist, dessen Ausgang wiederum mit der Eingangsklemme 100 des ersten Phasenregelkreises FPLL in Verbindung steht. Liegt das Farbfernsehsignal FBAS bereits digital vor, so kann selbstverständlich auf den Analog-Digital-Wandler verzichtet werden. Aus dem digitalen Farbfernsehsignal wird über eine Synchronimpulsabtrennstufe SA das Synchronsignal HS abgetrennt und einem Phasendetektor PD zugeführt. Der Ausgang dieses Phasendetektors PD ist mit einem zweiten Schleifenfilter SF2 mit nachgeschalteter Additionsstufe ADD2 in Verbindung, deren Ausgang mit einem Eingang eines zweiten Nachlaufoszillators DTO2 verbunden ist. Eine weitere Eingangsklemme dieses digitalen Nachlaufoszillators DTO2 wird von einer Quarzfrequenz $f_Q$ beaufschlagt, so daß am mit dem Phasendetektor PD verbundenen Ausgang des digitalen Nachlaufoszillators DTO2 ein Takt abgreifbar ist, der proportional dem Produkt aus der Quarzfrequenz $f_Q$ mit dem am Ausgang der zweiten Additionsstufe ADD2 abgreifbaren Inkrement $J_2$ ist. Der zweiten Eingangsklemme der zweiten Additionsstufe ADD2 wird ein Inkrement $J_N$ zugeführt, das der Sollfrequenz des zeilenverkoppelten Taktes entspricht. Am Ausgang des Schleifenfilters SF2 liegt in diesem zweiten Phasenregelkreis HPLL ein Inkrement $\Delta J_N$ an, das proportional zur Abweichung der aktuellen Taktfrequenz $Nf_H$ von der Solltaktfrequenz $Nf_{HO}$ ist.

Der Ausgang des zweiten Schleifenfilters SF2 dieses zweiten Phasenregelkreises HPLL wird einer Eingangsklemme 11 der bereits oben erwähnten Korrektureinrichtung KS zugeführt. Damit steht an der Eingangsklemme 11 dieser Korrektureinrichtung das Signal $\Delta J_N$ an, das die Abweichung der Frequenz des zeilenverkoppelten Taktes vom Sollwert $Nf_{HO}$ enthält. Über die Korrektureinrichtung KS wird dieses Signal $\Delta J_N$ in ein Korrektursignal $J_K$ umgeformt, das erfindungsgemäß mindestens annähernd umgekehrt proportional zur Frequenz des zeilenverkoppelten Taktes $Nf_H$ gewählt ist.

Zweckmäßigerweise wird das Korrektursignal $J_K$ in der Korrekturschaltung KS durch einen Umsetzalgorithmus gebildet, der aus dem an der Eingangsklemme 11 anliegendem Eingangswert, der proportional zur Abweichung der aktuellen Frequenz $Nf_H$ von der Solltaktfrequenz $Nf_{HO}$ ist, einen Ausgangswert bildet, der mindestens annähernd umgekehrt proportional zur Frequenz des zeilenverkoppelten Taktes $Nf_H$ ist.

Die Ausgangswerte und damit das Korrektursignal $J_K$ können beispielsweise aus Werten einer Geradengleichung gewonnen werden, die um einen Bereich eines Sollwertes des zeilenverkoppelten Taktes $Nf_H$ an einer Kurve approximiert ist, die durch inverse Werte $1/Nf_H$ der möglichen Frequenzen des zeilenverkoppelten Taktes $Nf_H$ bestimmt ist.

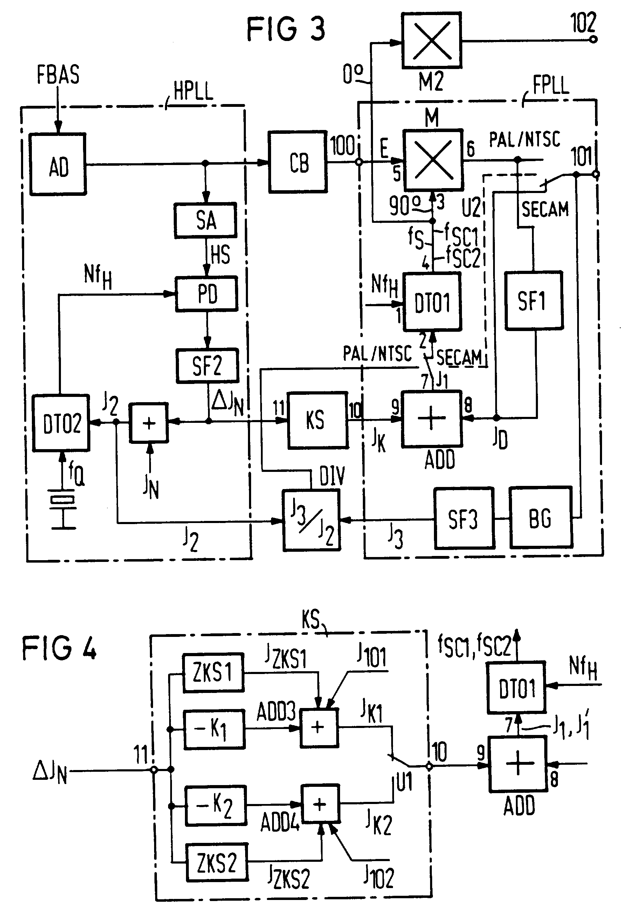

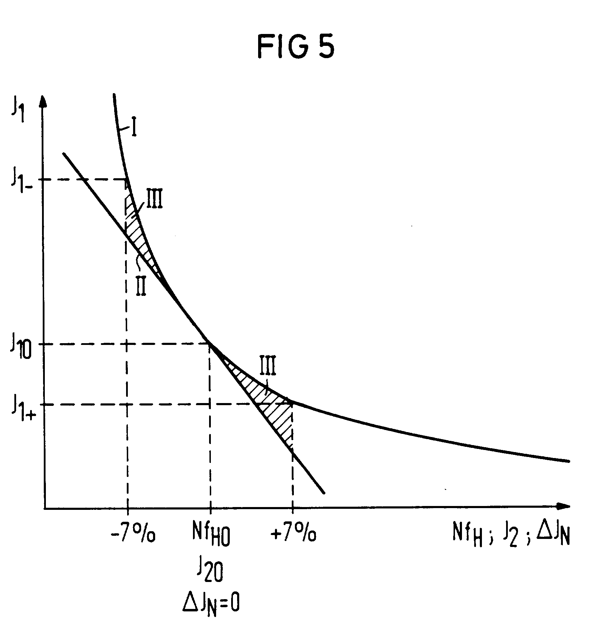

Anhand der FIG 4 und 5 wird beispielhaft gezeigt, wie das Korrektursignal $J_K$ mit Hilfe einer Geradengleichung gebildet werden kann. Dabei wird davon ausgegangen, daß im zweiten Phasenregelkreis HPLL der zweite digitale Nachlaufoszillator DTO2 mit einem Inkrement $J_2$ beaufschlagt wird, das direkt proportional zur augenblicklichen Frequenz des zeilenverkoppelten Taktes $Nf_H$ ist. Wie bei digitalen Nachlaufoszillatoren üblich, nämlich deren Ausgangsfrequenz propositional zum Produkt des Inkrementes mit der Quarzfrequenz, hier im zweiten Phasenregelkreis HPLL mit der Bitbreite n des zweiten digitalen Nachlaufoszillators DTO2 also

$$N f_H = \frac{J_2 \cdot f_Q}{2^n - 1} \tag{1}$$

Da die Quarzfrequenz $f_Q$ genau bekannt und absolut stabil ist, stellt das zweite Inkrement $J_2$ ein präzises Maß für die augenblickliche Frequenz des zeilenverkoppelten Taktes $Nf_H$ dar. Es gilt also

$$j_2 = \frac{N \cdot f_H}{f_Q} \cdot \left(2^n - 1\right) = \left(2^n - 1\right) \cdot \frac{N}{f_Q} \cdot (f_{HO} + \Delta f_H) = J_N + \Delta J_N \tag{2}$$

wobei $J_N$ das Inkrement für die Sollfrequenz des zeilenverkoppelten Taktes $Nf_H$ und $\Delta J_N$ das Inkrement für dessen Abweichung darstellt.

Da dieses zweite Inkrement $J_2$ ohnehin bei der Demodulation von PALL/NTSC-Fernsehsignalen gebildet werden muß, sieht eine Ausführungsform der Erfindung vor, aus diesem zweiten Inkrement $J_2$ ein Korrektursignal $J_K$ zu bilden, das mindestens annähernd umgekehrt proportional zur augenblicklichen Frequenz des zeilenverkoppelten Taktes $Nf_H$ ist. Zu dieser Umformung dient die Korrektureinrichtung KS.

Im einfachsten Fall könnten die zum zweiten Inkrement $J_2$ inversen Werte gebildet werden. Damit wäre jedoch in der Korrektureinrichtung KS eine arithmetische Teilung notwendig, die relativ viel Zeit beansprucht. Es wird deshalb eine Approximation der Kurve, die durch die inversen Werte $1/Nf_H$ der möglichen Frequenzen des zeilenverkoppelten Taktes $Nf_H$ bestimmmt ist, mittels einer Geraden vorgenommen. Das Prinzip dazu zeigt FIG 5.

Mit I ist die Kurve dargestellt, die durch die inversen Werte $1/Nf_H$ des zeilenverkoppelten Taktes $Nf_H$ gegeben ist, d. h. der ideale Verlauf für $J_K$, wenn $J_K$ vollständig Taktschwankungen von $Nf_H$ kompensiert. Dabei bezeichnet $Nf_{HO}$ die Sollfrequenz des zeilenverkoppelten Taktes $Nf_H$ und $J_{20}$ das dazugehörende Sollinkrement. Bei der Sollfrequenz $Nf_{HO}$ ist das Inkrement $\Delta J_N$, das die Abweichung von der Sollfrequenz $Nf_{HO}$ bestimmt, natürlich gleich Null. Schwingt der zeilenverkoppelte Takt $Nf_H$ auf dieser Sollfrequenz $Nf_{HO}$, so muß der erste digitale Nachlaufoszillator DTO1 mit dem Sollwert $J_{10}$ des ersten Inkrementes $J_I$ beaufschlagt werden, damit der Farbträger $f_{SC}$ stabil ist, d. h. $J_K = J_{10}$. Weicht dagegen die Frequenz des zeilenverkoppelten Taktes $Nf_H$ beispielsweise um minus 7% von der Sollfrequenz $Nf_{HO}$ ab, so muß das erste Inkrement $J_1$ den Wert $J_{1-}$ und bei einer Abweichung um plus 7% den Wert $J_{1+}$ annehmen, damit der Farbträger $f_{SC}$ stabil bleibt.

Gemäß der Weiterbildung der Erfindung wird die Kurve 1 zunächst durch die Gerade II approximiert. Die Geradengleichung dafür lautet

$$II = J_{10} + (-K) \cdot \Delta J_N \tag{3}$$

mit

$$K=\frac{f_{SC}\cdot\left(2^m-1\right)\cdot f_Q}{(N\cdot f_{HO})^2\cdot\left(2^n-1\right)}=\frac{f_{SC}\cdot\left(2^m-1\right)}{N\cdot f_{HO}\cdot J_2} \qquad (4)$$

$$K=\frac{J_{1-}-J_{1+}}{2\cdot\Delta J_N} \qquad (5)$$

Da alle Werte in (4) und (5) (m = Bitbreite des ersten digitalen Nachlaufoszillators DTO1) bekannt sind, kann die Steigung K der Geraden leicht ermittelt werden. Gemäß der Ausführungsform der Erfindung wird dann eine Gerade mit der Steigung K durch den Punkt, der durch $J_{10}$ und $\Delta J_N = 0$ bestimmt ist, gelegt. Damit ist die Approximation der Kurve I erreicht.

Der bei dieser Approximation auftretende geringe Fehler ist in FIG 5 durch die schraffierten Bereich III gekennzeichnet und kann durch eine Zusatzkorrekturschaltung ZKS - soweit erforderlich - kompensiert werden. Damit ergibt sich eine Korrektureinrichtung KS, wie diese in FIG 4 dargestellt und die beispielsweise mit dem ROM (Read Only Memory) realisierbar ist.

Das gesamte Korrektursignal ergibt sich mit dem Zusatz-Korrektursignal $J_{ZKS}$ somit zu

$$J_K=J_{10}+(-K)\cdot\Delta J_N+J_{ZKS} \qquad (6)$$

Die Korrektureinrichtung KS weist zwei Signalpfade auf, die jeweils der Gleichung (6) genügen und von denen ein Signalpfad für die Rotzeile und der andere Signalpfad für die Blauzeile des SECAM-codierten Farbfernsehsignales vorgesehen ist. So wird der dritten Additionsstufe ADD3 das Sollinkrement $J_{101}$ für das Generieren des Farbträgers $f_{SC1}$ für die Blauzeile und der vierten Additionsstufe ADD4 das dazu unterschiedliche Sollinkrement $J_{102}$ für das Generieren des Farbträgers $f_{SC2}$ der Rotzeile zugeführt. Das an der Eingangsklemme 11 der Korrektureinrichtung KS anliegende Inkrement $\Delta J_N$ wird in der Stufe K1 mit dem Faktor (- K1) für die Blauzeile und in der Stufe K2 mit dem Faktor (- K2) für die Rotzeile multipliziert. Zusätzlich kann in jedem Zweig die bereits oben angesprochene Zusatzkorrekturschaltung ZKSI, ZKS2 vorgesehen werden, die im wesentlichen eine nichtlineare Korrekturschaltung beinhaltet. Am Ausgang der dritten Additionsstufe ADD3 steht damit das Korrektursignal $J_{KI}$ für die Blauzeile und am Ausgang der vierten Additionsstufe ADD4 das Korrektursignal $J_{K2}$ für die Rotzeile an, die zeitrichtig über die Umschalteinrichtung U1 an die Eingangsklemme 9 der ersten Additionsstufe ADD gelegt werden. Damit stehen an der Eingangsklemme 2 des ersten digitalen Nachlaufoszillators DTO1 abwechselnd zwei Inkremente $J_1$, $J_1'$ an, die multipliziert mit dem zeilenverkoppelten Takt, der jetzt auch Taktschwankungen aufweisen kann, einen ersten stabilen Farbträger $f_{SC1}$ für die Rotzeile und einen zweiten stabilen Farbträger $f_{SC2}$ für die Blauzeile ergeben.

In FIG 3 ist ein Prinzipschaltbild für eine Schaltungsanordnung eines Multistandard-Farbdecoders für Farbfernsehsignale gezeigt. Diese Schaltungsanordnung weist neben dem im Zusammenhang mit FIG 2 bereits erläuterten SECAM-Decoder zusätzlich Schaltungskomponenten zur Chrominanzdemodulation von PAL/NTSC-codierten Farbfernsehsignalen auf, wie diese für sich genommen aus der eingangs erwähnten Elektronik 5/6, 1987, Seite 107, Bild 3 bekannt sind. Die Schaltungsanordnung nach FIG 2 ist in FIG 3 um folgende Schaltungskomponenten ergänzt: Einen zweiten Modulator M2, eine Burstgate-Schaltung BG, ein drittes Schleifenfilter SF3, eine Divisionsstufe DIV sowie eine zweite Umschalteinrichtung U2. Befindet sich diese Umschalteinrichtung U2 in der Stellung SECAM, so wie es in FIG 3 gezeigt ist, so liegen an der Ausgangsklemme 4 des ersten digitalen Nachlaufoszillators DTO1 abwechselnd der phasenstabile Farbträger $f_{SCI}$ für die Blauzeile und der phasenstabile Farbträger $f_{SC2}$ für die Rotzeile des Farbfernsehsignales an. Das demodulierte Chrominanzsignal ED ist an der Klemme 101 des ersten Phasenregelkreises FPLL abgreifbar. Befindet sich dagegen die zweite Umschalteinrichtung U2 in der Stellung PAL/NTSC, so generiert der erste digitale Nachlaufoszillator DTO1 einen phasenstabilen Farbträger $f_S$, der dem Modulator M und um -90° phasenverschoben dem zweiten Modulator M2 zugeführt wird, wodurch am Ausgang 101 des zweiten Phasenregelkreises FPLL das Chrominanzsignal V und an der Klemme 102 das Chrominanzsignal U des demodulierten PAL/NTSC-anliegt.

Für die SECAM-Demodulation wird an den Ausgang 101 noch ein an sich SECAM-Kreuzschalter angeschlossen, der der besseren Übersichtlichkeit jedoch nicht dargestellt ist.

Anzumerken ist noch, daß die Zeitkonstanten der Schleifenfilter SF1 und SF3 entsprechend der in der Beschreibungseinleitung gemachten Ausführung unterschiedlich gewählt werden müssen.

Besonders geeignet ist die erfindungsgemäße Schaltungsanordnung zur Verwendung in einem Gerät, das Farbvideosignale empfängt, also insbesondere Farbfernsehgeräte und Videorekorder.

**Patentansprüche**

1. Verfahren zur Demodulation von SECAM-codierten Farbfernsehsignalen mit zeilenverkoppeltem Takt

**dadurch gekennzeichnet,**

daß in einem ersten Phasenregelkreis (FPLL) ein zu demodulierendes Chrominanzsignal E mit einem phasenstabilen Farbträger ($f_{SC}$) multipliziert und anschließend mindestens einem ersten Schleifenfilter (SF1) zugeführt wird, an dessen Ausgang das demodulierte Chrominanzsignal (ED) anliegt,

daß der phasenstabile Farbträger ($f_{SC}$) als Ausgangssignal eines ersten digitalen Nachlaufoszillators (DTO1) gewonnen wird, wobei die Frequenz des Ausgangssignales dem Produkt eines Inkrements ($J_1$) mit dem zeilenverkoppelten Takt ($Nf_H$) proportional ist,

daß das Inkrement ($J_1$) aus der Addition des demodulierten Chrominanzsignales (ED) und einem Korrektursignal ($J_K$) gebildet wird, das umgekehrt proportional zur Frequenz des zeilenverkoppelten Taktes ($Nf_H$) gewählt ist, und

daß in einem zweiten Phasenregelkreis (HPLL) der zeilenverkoppelte Takt ($Nf_H$) aus einem Synchronsignal (HS) des Farbfernsehsignales (FBAS) abgeleitet wird, indem einem zweiten digitalen Nachlaufoszillator (DTO2) eine quarzstabile Taktfrequenz ($f_Q$) sowie ein zweites Inkrement ($J_2$), das proportional zur jeweiligen Frequenz des zeilenverkoppelten Taktes ($Nf_H$) ist, zugeführt wird und aus diesem zweiten Inkrement ($J_2$) das Korrektursignal ($J_K$) abgeleitet wird.

2. Verfahren nach Anspruch 2,
   **dadurch gekennzeichnet,**
   daß aus einer Abweichung ($\Delta J_N$) vom zweiten Inkrement ($J_2$), das einer Sollfrequenz des zeilenverkoppelten Taktes ($Nf_H$) entspricht, das Korrektursignal ($J_K$) abgeleitet wird.

3. Verfahren nach einem der Ansprüche 1 oder 2,
   dadurch gekennzeichnet,
   daß das Korrektursignal ($J_K$) durch einen Umsetzalgorithmus gebildet wird, der aus einem Eingangswert, der proportional zur Frequenz des zeilenverkoppelten Taktes ($Nf_H$) ist, einen Ausgangswert bildet, der mindestens annähernd umgekehrt proportional zur Frequenz des zeilenverkoppelten Taktes ($Nf_H$) ist.

4. Verfahren nach einem der Ansprüche 1 bis 3 ,
   **dadurch gekennzeichnet,** daß das Korrektursignal aus Werten einer Geradengleichung gewonnen wird, die um einen Bereich eines Sollwertes des zeilenverkoppelten Taktes ($Nf_H$) an einer Kurve approximiert ist, die durch inverse Werte ($1/Nf_H$) der möglichen Frequenzen des zeilenverkoppelten Taktes ($Nf_H$) bestimmt ist.

5. Verfahren nach einem der Ansprüche 1 bis 4,
   dadurch gekennzeichnet,

   daß zwei Korrektursignale ($J_{K1}$, $J_{K2}$) gebildet werden,

   daß das eine Korrektursignal ($J_{K1}$) für eine Rotzeile und das andere Korrektursignal ($J_{K2}$) für eine Blauzeile des Chrominanzsignales gebildet wird, und

   daß zwischen diesen Korrektursignalen ($J_{K1}$, $J_{K2}$) abwechselnd umgeschaltet wird, wobei eine phasenstabile Farbträgerfrequenzen ($f_{SC1}$) für eine Rotzeile und phasenstabile Farbträgerfrequenz ($f_{SC2}$) eine Blauzeile gebildet werden.

6. Schaltungsanordnung zur Demodulation von SECAM-codirten Farbfernsehsignalen mit Zeilenverkoppeltem Takt, zur Durchführung des Verfahrens nach einem der Ansprüche 1 bis 5,
   **gekennzeichnet** durch

   - einen ersten Phasenregelkreis (FPLL), der aufweist:

   - einen ersten digitalen Nachlaufoszillator (DTO1) mit einer ersten Eingangsklemme (1) zum Anlegen eines zeilenverkoppelten Taktes ($Nf_H$) und eine zweite Eingangsklemme (2) zum Anlegen eines ersten Inkrementes ($J_1$),

   - einen Modulator (M), dessen erste Eingangsklemme (3) mit einer Ausgangsklemme (4) des ersten digitalen Nachlaufoszillators (DTO1) verbunden ist und an dessen zweite Eingangsklemme (5) ein zu demodulierendes Chrominanzsignal (ED) anlegbar ist,

- ein erstes Schleifenfilter (SF1), das zwischen eine Ausgangsklemme (6) des Modulators (M) und einem Ausgang (A) des ersten Phasenregelkreises (FPLL) geschaltet ist,

- eine Additionsstufe (ADD), deren Ausgangsklemme (7) mit der zweiten Eingangsklemme (2) des ersten digitalen Nachlaufoszillators (DTO1) verbunden ist, und deren erste Eingangsklemme (8) an den Ausgang (A) des ersten Phasenregelkreises (FPLL) angeschlossen ist, und

- eine Korrektureinrichtung (KS) zum Generieren mindestens eines Korrektursignales ($J_K$), das mindestens annähernd umgekehrt proportional zur Frequenz des zeilenverkoppelten Taktes ($Nf_H$) ist, wobei eine Ausgangsklemme (10) dieser Korrektureinrichtung (KS) mit einer zweiten Eingangsklemme (9) der Additionsstufe (ADD) verbunden ist, und

daß eine Eingangsklemme (11) der Korrektureinrichtung (KS) mit einer Ausgangsklemme (12) eines zweiten Schleifenfilters (SF2) verbunden ist, das Bestandteil eines zweiten Phasenregelkreises (HPLL) ist, der zum Generieren des zeilenverkoppelten Taktes ($Nf_H$) aus einem Synchronsignal (HS) des Farbfernsehsignales (FBAS) geeignet ist.

7. Schaltungsanordnung nach Anspruch 6,
**dadurch gekennzeichnet,**

daß die Korrektureinrichtung (KS) zum Generieren zweier Korrektursignale ($J_{K1}$, $J_{K2}$) vorgesehen ist,

daß der Korrektureinrichtung (KS) eine erste Umschalteinrichtung (U1) nachgeschaltet ist, und daß durch diese erste Umschalteinrichtung (U1) abwechselnd eines der beiden Korrektursignale ($J_{K1}$, $J_{K2}$) an die zweite Eingangsklemme (9) der Additionsstufe (ADD) schaltbar ist.

8. Schaltungsanordnung nach Anspruch 6 oder 7,
**dadurch gekennzeichnet,** daß der erste Phasenregelkreis (FPLL) zusätzlich Mittel zur Demodulation von amplitudenmodulierten Farbsignalen aufweist, die über eine Umschalteinrichtung ($U_2$) aktivierbar sind.

9. Gerät zum Empfang von Farbvideosignalen, insbesondere Fernsehgerät oder Videorecorder, gekennzeichnet durch eine Schaltungsanordnung nach einem der Ansprüche 6 bis 8.

## Claims

1. Method for demodulation of SECAM-coded colour television signals with a line-coupled clock, characterized in that a chrominance signal E, which is to be demodulated, is multiplied by a phase-stabilized colour sub-carrier ($f_{SC}$) in a first phase locked loop (FPLL) and is subsequently fed to at least one first loop filter (SF1) and at whose output the demodulated chrominance signal (ED) is present, in that the phase-stabilized colour sub-carrier ($f_{SC}$) is obtained as the output signal of a first digital tracking oscillator (DTO1), the frequency of the output signal being proportional to the product of an increment ($J_1$) and the line-coupled clock ($Nf_H$), in that the increment ($J_1$) is formed from the addition of the demodulated chrominance signal (ED) and a correction signal ($J_K$) which is selected to be inversely proportional to the frequency of the line-coupled clock ($Nf_H$), and in that the line-coupled clock ($Nf_E$) is derived in a second phase locked loop (HPLL) from a synchronization signal (HS) of the colour television signal (FBAS) in that a second digital tracking oscillator (DT02) is fed with a crystalstabilized clock frequency ($f_Q$) and with a second increment ($J_2$) which is proportional to the respective frequency of the line-coupled clock ($Nf_M$) , and the correction signal ($J_K$) is derived from this second increment ($J_2$).

2. Method according to Claim 2, characterized in that the correction signal ($J_K$) is derived from an error ($\Delta J_N$) of the second increment ($J_2$), which second increment ($J_2$) corresponds to a required frequency of the line-coupled clock ($Nf_H$).

3. Method according to one of Claims 1 or 2, characterized in that the correction signal ($J_{K,}$) is formed by a conversion algorithm which forms an output value from an input value which is proportional to the frequency of the line-coupled clock ($Nf_H$), which output value is at least approximately inversely proportional to the frequency of the line-coupled clock ($Nf_H$) .

4. Method according to one of Claims 1 to 3, characterized in that the correction signal is obtained from values of a first order equation which is approximated to a curve about a region of a required value of the line-coupled clock ($Nf_H$), which curve is determined by inverse values ($1/Nf_H$) of the possible frequencies of the line-coupled clock ($Nf_H$).

5. Method according to one of Claims 1 to 4, characterized in that two correction signals ($J_{K1}$, $J_{K2}$) are formed, in that one ($J_1$) of these correction signals is formed for a red line and the other correction signal ($J_{K2}$) is formed for a blue line of the chrominance signal, and in that switching over between these correction signals ($J_{K1}$, $J_{K2}$) takes place alternately, a phase-stabilized colour sub-carrier frequency ($f_{SC1}$) being formed for a red line and a phase-stabilized colour sub-carrier frequency ($f_{SC2}$) being formed for a blue line.

6. Circuit arrangement for demodulation of SECAM-coded colour television signals with a line-coupled clock, for carrying out the method according to one of Claims 1 to 5, characterized by

   - a first phase locked loop (FPLL) which has:

   - a first digital tracking oscillator (DT01) having a first input terminal (1) for the application of a line-coupled clock ($Nf_K$) and a second input terminal (2) for the application of a first increment ($J_1$),

   - a modulator (M) whose first input terminal (3) is connected to an output terminal (4) of the first digital tracking oscillator (DT01) and to whose second input terminal (5) a chrominance signal (ED), which is to be demodulated, can be applied,

   - a first loop filter (SF1) which is connected between an output terminal (6) of the modulator (M) and an output (A) of the first phase locked loop (FPLL),

   - an addition stage (ADD), whose output terminal (7) is connected to the second input terminal (2) of the first digital tracking oscillator (DT01) and whose first input terminal (8) is connected to the output (A) of the first phase locked loop (FPLL), and

   - a correction device (KS) for the generation of at least one correction signal ($J_k$) which is at least approximately inversely proportional to the frequency of the line-coupled clock ($Nf_H$), an output terminal (10) of this correction device (KS) being connected to a second input terminal (9) of the addition stage (ADD), and

   in that an input terminal (11) of the correction device (KS) is connected to an output terminal (12) of a second loop filter (SF2) which is a component of a second phase locked loop (HPLL) which is suitable for the generation of the line-coupled clock ($Nf_H$) from a synchronization signal (HS) of the colour television signal (FBAS).

7. Circuit arrangement according to Claim 6, characterized in that the correction device (KS) is provided for the generation of two correction signals ($J_{K1}$, $J_{K2}$), in that a first changeover device (U1) is connected downstream of the correction device (KS), and in that one of the two correction signals ($J_{K1}$, $J_{K2}$) can alternately be connected to the second input terminal (9) of the addition stage (ADD) by means of this first changeover device (U1).

8. Circuit arrangement according to Claim 6 or 7, characterized in that the first phase locked loop (FPLL) additionally has means for demodulation of amplitude-modulated colour signals, which means can be activated via a changeover device ($U_2$).

9. Apparatus for the reception of colour video signals, in particular a television set or video recorder, characterized by a circuit arrangement according to one of Claims 6 to 8.


**Revendications**

1. Procédé de démodulation de signaux de télévision en couleurs à codage SECAM, comportant une cadence couplée aux lignes,
   caractérisé par le fait

que dans un premier circuit de régulation de phase (FPLL), un signal de chrominance (E) devant être démodulé est multiplié par une porteuse couleur ($f_{SC}$) à phase stable et ensuite est envoyé au moins à un premier filtre de boucle (SF1), à la sortie duquel est présent le signal de chrominance démodulé (ED),

que la porteuse couleur ($f_{SC}$) à phase stable est obtenue en tant que signal de sortie d'un premier oscillateur numérique d'asservissement (DTO1), la fréquence du signal de sortie étant proportionnelle au produit d'un incrément ($J_1$) par la cadence ($Nf_H$) couplée aux lignes,

que l'incrément ($J_1$) est formé par l'addition du signal de chrominance démodulée (ED) et d'un signal de correction ($J_K$), qui est choisi inversement proportionnel à la fréquence de la cadence ($Nf_H$) couplée aux lignes, et

que dans un second circuit de régulation de phase (HPLL), la cadence ($Nf_H$) couplée aux lignes est dérivée d'un signal de synchronisation (HS) du signal de télévision en couleurs (FBAS), par le fait qu'une fréquence de cadence ($f_Q$) stabilisée par quartz ainsi qu'un second incrément ($J_2$), qui est proportionnel à la fréquence de la cadence ($Nf_H$) couplée aux lignes, sont envoyés à un second oscillateur numérique asservi (DTO2), et que le signal de correction ($J_K$) est dérivé de ce second incrément ($J_2$).

2. Procédé suivant la revendication 1, caractérisé par le fait que le signal de correction ($J_K$) est dérivé d'un écart ($\Delta J_N$) par rapport au second incrément ($J_2$), qui correspond à une fréquence de consigne de la cadence ($Nf_H$) couplée aux lignes.

3. Procédé suivant l'une des revendications 1 ou 2, caractérisé par le fait que le signal (K) est formé par un algorithme de conversion, qui forme, à partir d'une valeur d'entrée, qui est proportionnelle à la fréquence de la cadence ($Nf_H$) couplée aux lignes, une valeur de sortie qui est au moins approximativement inversement proportionnelle à la fréquence de la cadence ($Nf_H$) couplée aux lignes.

4. Procédé suivant l'une des revendications 1 à 3, caractérisé par le fait que le signal de correction est obtenu à partir de valeurs d'une équation de droite, qui est ajustée de façon approximative, dans une zone d'une valeur de consigne de la cadence ($Nf_H$) couplée aux lignes, à une courbe qui est déterminée par des valeurs inverses ($1/Nf_H$) des fréquences possibles de la cadence ($Nf_H$) couplée aux lignes.

5. Procédé suivant l'une des revendications 1 à 4, caractérisé par le fait

que deux signaux de correction ($J_{K1}$, $J_{K2}$) sont formés,

qu'un signal de correction ($J_{K1}$) est formé pour une ligne rouge et que l'autre signal de correction ($J_{K2}$) est formé pour une ligne bleue du signal de chrominance, et

qu'une commutation est exécutée en alternance entre ces signaux de correction ($J_{K1}$, $J_{K2}$), une fréquence porteuse couleur ($f_{SC1}$) à phase stable étant formée par une ligne rouge et une fréquence porteuse couleur ($f_{SC2}$) à phase stable étant formée pour une ligne bleue.

6. Montage de démodulation de signaux de télévision à codage SECAM avec une cadence couplée aux lignes, pour la mise en oeuvre du procédé suivant l'une des revendications 1 à 5, caractérisé par

- une première boucle de régulation de phase (FPLL), qui possède :

- un premier oscillateur numérique asservi (DTON) possédant une première borne d'entrée (1) pour l'application d'une cadence ($nF_H$) couplée aux lignes et une seconde borne d'entrée (2) pour l'application d'un premier incrément ($J_3$),

- un modulateur (M), dont la première borne d'entrée (3) est reliée à une borne de sortie (4) du premier oscillateur numérique asservi (DTO1) et à la seconde borne d'entrée (5) duquel peut être appliqué un signal de chrominance (ED) devant être démodulé,

- un premier filtre de boucle (SF1), qui est branché entre une borne de sortie (6) du modulateur (M) et une sortie (A) du premier circuit de régulation de phase (FPLL),

- un étage additionneur (ADD), dont la borne de sortie (7) est reliée à la seconde borne d'entrée (2) du premier oscillateur numérique asservi (DDO1) et dont la première borne d'entrée (8) est raccordée à la sortie (N) du premier circuit de régulation de phase (FPLL), et

- un dispositif de correction (KS) servant à produire au moins un signal de correction ($J_K$), qui est au moins approximativement inversement proportionnel à la fréquence de la cadence ($Nf_H$) couplée aux lignes, une borne de sortie (10) du dispositif de correction (KS) étant reliée à une seconde borne d'entrée (9) de l'étage additionneur (ADD), et

qu'une borne d'entrée (11) du dispositif de correction (KS) est reliée à une borne de sortie (12) d'un second filtre de boucle (SF2), qui fait partie d'un second circuit de régulation de phase (HPLL), qui convient pour la production de la cadence ($Nf_H$) couplée aux lignes, à partir d'un signal de synchronisation (HS) du signal de télévision en couleurs (FBAS).

7. Montage suivant la revendication 6, caractérisé par le fait que le dispositif de correction (KS) est prévu pour la production de deux signaux de correction ($J_{K1}$, $J_{K2}$), qu'en aval du dispositif de correction (KS) est branché un premier dispositif de commutation (U1), et que l'un des deux signaux de commutation ($J_{K1}$, $J_{K2}$) peut être appliqué alternativement, par ce premier dispositif de commutation (U1), à la seconde borne d'entrée (9) de l'étage additionneur (ADD).

8. Montage suivant la revendication 6 ou 7, caractérisé par le fait que le premier circuit de régulation de phase (PLL) comprend en outre des moyens pour démoduler des signaux de couleurs, modulés en amplitude, et qui peuvent être activés par l'intermédiaire d'un dispositif de commutation ($U_2$).

9. Appareil pour la réception de signaux vidéo couleurs, notamment appareil de télévision ou enregistreur vidéo, caractérisé par un montage suivant l'une des revendications 6 à 8.

## FIG 1

## FIG 2

# FIG 3

FBAS

HPLL

AD

CB — 100

SA

HS

PD

Nf$_H$

SF2

$\Delta J_N$

DT02 — J$_2$

+

J$_N$

f$_Q$

11 — KS — 10

9

J$_K$

0°

M2

102

FPLL

M

E — 5 — 6 — PAL/NTSC — 101

90° — 3 — U2 — SECAM

f$_S$ — f$_{SC1}$ — f$_{SC2}$ — 4

Nf$_H$ — DT01 — 1 — SF1

2

PAL/NTSC — SECAM

7 — J$_1$

+ — 8

J$_D$

ADD

DIV

J$_3$/J$_2$

J$_2$

J$_3$

SF3 — BG

# FIG 4

KS

ZKS1 — J$_{ZKS1}$ — J$_{101}$

−K$_1$ — ADD3 — + — J$_{K1}$

$\Delta J_N$ — 11

−K$_2$ — ADD4 — + — J$_{K2}$

ZKS2 — J$_{ZKS2}$ — J$_{102}$

U1

10 — 9

f$_{SC1}$,f$_{SC2}$ — DT01 — Nf$_H$

7 — J$_1$,J$_1'$

+ — 8

ADD

# FIG 5